Europäisches Patentamt

European Patent Office

Office européen des brevets

(11) Publication number: **0 044 702**
**B1**

# EUROPEAN PATENT SPECIFICATION

(45) Date of publication of patent specification: **27.12.84**

(51) Int. Cl.³: **H 01 L 41/18, H 01 L 37/02**

(21) Application number: **81303250.5**

(22) Date of filing: **15.07.81**

(54) Piezoelectric and pyroelectric polymeric blends.

(30) Priority: **23.07.80 US 171279**

(43) Date of publication of application:
**27.01.82 Bulletin 82/04**

(45) Publication of the grant of the patent:
**27.12.84 Bulletin 84/52**

(84) Designated Contracting States:
**DE FR GB IT**

(56) References cited:
**US-A-3 607 754**
**US-A-3 660 736**
**US-A-3 967 027**

(73) Proprietor: **MINNESOTA MINING AND MANUFACTURING COMPANY**
**3M Center, P.O. Box 33427**
**St. Paul, MN 55133 (US)**

(72) Inventor: **Krueger, Dennis, L.**
**2501 Hudson Road P.O. Box 33427**
**St. Paul, Minnesota 55133 (US)**
Inventor: **Loeding, Neil W.**
**2501 Hudson Road P.O. Box 33427**
**St. Paul, Minnesota 55133 (US)**
Inventor: **Poser, Claudia, I.**
**2501 Hudson Road P.O. Box 33427**
**St. Paul, Minnesota 55133 (US)**

(74) Representative: **Baillie, Iain Cameron et al**
**c/o Ladas & Parry Isartorplatz 5**
**D-8000 München 2 (DE)**

Courier Press, Leamington Spa, England.

# 0 044 702

**Description**

**Technical Field**

The invention relates to a polymeric film or coating which is capable of displaying pyroelectric and isotropic piezoelectric properties, and more particularly relates to a blend of polymers which allows the formation of a pyroelectric and isotropic piezoelectric film without the necessity of mechanical orientation, i.e., the mechanical stretching or elongation, of the film.

**Background Art**

Certain polymeric films have been found to be capable of exhibiting pyroelectric properties, i.e., capable of reacting, in terms of electrical charge polarization, to a change in temperature of the material, and piezoelectric properties, i.e., capable of reacting in the same manner to changes in strain of said film. These films are typically poled, which essentially involves the application of an intense electric field gradient thereto. In essence, the film after poling retains an electrical polarization and becomes substantially stable relative thereto unless changes in strain (piezoelectric) or temperature (pyroelectric) occur. One such film which has found exceptional use in this area is polyvinylidene fluoride.

Polyvinylidene fluoride, when manufactured in film form, such as by an extruder, etc., has a crystalline structure which is in essence of the alpha type. It has been found, however, that the alpha crystalline film, when poled, does not provide a film displaying sufficient pyroelectric or piezoelectric properties for practical utility. Therefore, the crystallinity of the film is typically changed to the beta type, which is susceptible to successful poling to render the film sufficiently pyroelectric and piezoelectric. Typically, this change in the crystalline structure from alpha to beta is undertaken by biaxial or uniaxial orientation, i.e., stretching the film in a heated state and retaining same in the stretched state while the film is allowed to cool. The resultant film exhibits the beta crystallinity which can, as aforementioned, be successfully poled to render same pyroelectric and piezoelectric.

We have now found that by using a blend of polymers, processing of same to a film or a coating on an article can be undertaken without the necessity of mechanical orientation of the film to the beta crystallinity, and yet a film or coating displaying pyroelectric and isotropic piezoelectric characteristics can be obtained.

**Disclosure of Invention**

In accordance with the invention there is provided a method for producing a polymeric film or coating capable of displaying pyroelectric and isotropic piezoelectric properties, the process comprising either solvent casting or melt blending a polymer blend into film form or coating onto an article, heating the film to a temperature above the melting point of the polyvinylidene fluoride for a sufficient time to render the film substantially amorphous, cooling the film at a rate and to a temperature sufficient to prevent the crystallization of the film, followed by polarization thereof to render the film pyroelectric and isotropically piezoelectric, and the film or article which results therefrom. The resultant film is not mechanically oriented and comprises a blend of polyvinylidene fluoride and at least one polymer which is miscible with the polyvinylidene fluoride at a temperature above the melting point thereof.

**Best Mode for Carrying Out the Invention**

The polyvinylidene fluoride polymer utilized in this invention is of any of those types which are commercially available. Exemplary materials include Kureha 1100 (available from Kureha Chemical), Solvay 1012 (available from Soltex Polymer Corp.), and Kynar 301-F (available from Pennwalt Corp.).

The other polymers suitable for use in the polymer blend include those which are miscible with polyvinylidene fluoride, at a temperature above the melting point of the polyvinylidene fluoride. Miscibility herein means that the polymer blend exhibits a single glass transition temperature. Exemplary polymers include acrylates, e.g., polymethylacrylate; methacrylates, e.g., polymethylmethacrylate and polyethylmethacrylate; and polyvinylacetate.

In order to optimize the pyroelectric and piezoelectric characteristics of the polymer film, the blend should contain at least about 50 percent polyvinylidene fluoride, the balance being the polymers exemplified above.

In the preparation of the polymer film comprising the aforementioned blend, the polymers can be intimately mixed (in batch mixers such as the Banbury-type and roll mill type or in continuous mixers such as single and twin screw extruders) at an elevated temperature, typically called melt blending, until a uniform homogeneous mixture is obtained, following which a film can be prepared from the homogeneous mixture utilizing conventional equipment, such as an extruder, etc.

Alternatively, the polymers can be dissolved in a suitable solvent for application by conventional solvent casting techniques, e.g., spin casting, dip coating, knife coating, roll bar coating, spraying, etc. An exemplary solvent is dimethyl formamide. Solvent casting can be undertaken on articles such as metallic foil, integrated circuits, etc. This technique has special utility for coating an article such as where requirements such as small size or the necessity of direct electrical communication between article elements precludes the use of prepoled and subsequently adhered film.

In light of the foregoing, the term "film" should be construed to include both the self-supporting

2

web and a coating applied to an article.

The resultant film is then heated to remove the solvent therefrom, as in the case of solvent casting, and then heated to a temperature above the melting point of the polyvinylidene fluoride for sufficient time to render the film substantially amorphous. Following this heating step, the film is cooled at a rate and to a temperature sufficient to prevent the crystallization of the film.

If a metallic substrate is used, same can typically be selected from thin metal or alloy foils, examples of which include aluminum, copper, chromium, various steels, etc. In the case of solvent casting, thin metal films are preferred in order to provide rapid heat transfer so that the solvent from the coating solution will readily evaporate. Furthermore, in the subsequent heating step, after either solvent casting or melt blending, the thin metal film acts as a heat transfer medium to provide rapid cooling and thus prevent crystallization of the polymers in the film. Other substrates useful for receiving the polymer film include glass, ceramic (especially woven or non-woven ceramic fabrics), silicon, etc.

Additionally, the polymer blend can be solvent cast onto selected areas of devices, processed as above, and poled in situ to utilize the piezoelectric and pyroelectric properties of the polymer blend.

A film may or may not be removed from a metal web and poled by conventional static methods, or the film can be continuously poled as described in U.S. Patent Nos. 4,067,056; 4,079,437; or 4,089,034. During the poling operation, the substantially amorphous polymeric polyvinylidene fluoride is converted to the beta crystalline form under the influence of the electric field. In this fashion, the resultant polarized film is substantially in the beta crystalline form, without necessity for mechanical orientation of the film, because the maintaining of the blend in the substantially amorphous form prior to polarization avoids the formation of the alpha crystalline form of the polyvinylidene fluoride.

Furthermore, by the use of our process, the resultant polarized film exhibits isotropic piezoelectric properties in the plane of the film. By isotropic piezoelectric properties we mean that the piezoelectric constant $d_{31}$ is equal to $d_{32}$. In defining the piezoelectric constant, designations 1 and 2 correspond to any orthogonal directions in the plane of the film and designation 3 corresponds to a direction perpendicular to the plane of the film.

Alternatively, when mechanical orientation is undertaken to achieve the beta-crystalline form, such equality cannot typically be obtained in commercial practice.

The invention will now be more specifically described by the use of the following non-limiting examples, wherein all parts are by weight unless otherwise specified.

### Example 1

Mixtures of polyvinylidene fluoride (Kynar® 301-F from Pennwalt) and polymethylmethacrylate (Rohm and Hass Acryloid® A-11) were dissolved in dimethylformamide (DMF) by stirring and heating to 120°—160°C over a three hour period. Films were cast from a portion of the resulting solutions onto 1.0 mil (0.025 mm) thick aluminum foil using a six inch (15.24 cm) draw bar coater. The coated foil was immediately placed on a 150°C hot plate for 15 minutes to drive off most of the DMF, and then the coated foil was placed in a 150°—200°C oven for one-half hour. Just prior to poling, the coated foil was heated to 220°—240°C for 15 minutes and then rapidly cooled to room temperature. The resulting films, which measured about 1.0 mil (0.025 mm) thick, were poled as described in U.S. Patent Nos. 4,067,056; 4,079,437; or 4,089,034.

| Sample | PVF$_2$[1] | PMMA[2] | DMF[3] | KV[4] | Time[5] (sec) | p[6] (volts/ mil °C) |
|--------|-----------|---------|--------|-------|---------------|----------------------|
| A | 8 | 2 | 40[a] | 6 | 8 | 6.3 |
| B | 8 | 3.4 | 45.6[b] | 6 | 8 | 4.95 |
| C | 7 | 4.7 | 46.8 | 6 | 33 | 0.81 |

[a] Ten grams of DMF were added to the solution just prior to casting.
[b] Five grams of DMF were added to the solution just prior to casting.
NOTE: The additions (a) and (b) provided both solutions with about the same viscosity.
[1] PVF$_2$ — polyvinylidene fluoride resin, grams.
[2] PMMA — polymethylmethacrylate resin, grams.
[3] DMF — dimethylformamide, grams.
[4] KV — poling voltage, kilovolts.
[5] Time — residence time in field during poling.
[6] p — calculated pyroelectric response for blend.

### Example 2

Mixtures of polyvinylidene fluoride (SOLEF® 1012 from Solvay) and polymethylmethacrylate (Rohm and Haas Acryloid® A-11) were dissolved in dimethylformamide (DMF) by stirring and heating to 120°—160°C over a three hour period. Films were cast from a portion of the resulting solutions onto 0.6 mil thick aluminum foil using a six inch (15.24 cm) draw bar coater. The coated foil was immediately placed on a 130°C hot plate for 10 minutes to drive off most of the DMF, and then the coated foil was placed in a press for 10 minutes, the press platens having been heated to 220°C. A gap of at least one centimeter was maintained between the platens. Immediately after heating and just prior to poling, the films were quenched in ice water. The resulting films, whose thickness varied from 0.8 to 1.1 mil (0.020 to 0.028 mm) thick, were poled as described in U.S. Patent Nos. 4,067,056; 4,079,437; or 4,089,034.

| Sample | PVF$_2$[1] | PMMA[2] | DMF[3] | KV[4] | Time[5] (sec) | p[6] (volts/ mil °C) |
|--------|-----------|---------|--------|-------|---------------|----------------------|
| D | 6.5 | 3.5 | 40 | 6 | 8 | 3.1 |
| E | 7.5 | 2.5 | 40 | 6 | 8 | 3.8 |
| F | 9.0 | 1.0 | 40 | 6 | 8 | 3.3 |

[1] PVF$_2$ — polyvinylidene fluoride resin, grams.
[2] PMMA — polymethylmethacrylate resin, grams.
[3] DMF — dimethylformamide, grams.
[4] KV — poling voltage, kilovolts.
[5] Time — residence time in field during poling.
[6] p — calculated pyroelectric response for blend.

Example 3

Mixtures of polyvinylidene fluoride (SOLEF® 1012 from Solvay) and polyvinyl acetate (CAT No. 346 from Scientific Polymer Products) were dissolved in dimethylformamide (DMF) by stirring and heating to 120°—160°C over a three hour period. Films were cast from a portion of the resulting solution onto 0.6 mil thick aluminum foil using a six inch (15.24 cm) draw bar coater. The coated foil was immediately placed on a 130°C hot plate for 10 minutes to drive off most of the DMF, and then the coated foil was heated to 220°C for 10 minutes and then rapidly cooled by quenching in ice water. The resulting films, whose thickness varied from 1.0 to 1.2 mils (0.025 to 0.030 mm), were poled as described in U.S. Patent Nos. 4,067,056; 4,079,434434437; or 4,089,034.

| Sample | PVF$_2$[1] | PVAc[2] | DMF[3] | KV[4] | Time[5] (sec) | p[6] (volts/ mil °C) |
|--------|-----------|---------|--------|-------|---------------|----------------------|
| A | 6 | 4 | 40 | 6 | 8 | 3.7 |
| B | 7 | 3 | 40 | 6 | 8 | 4.5 |
| C | 8 | 2 | 40 | 6 | 8 | 5.5 |

[1] PVF$_2$ — polyvinylidene fluoride resin, grams.
[2] PVAc — polyvinyl acetate resin, grams.
[3] DMF — dimethylformamide, grams.
[4] KV — poling voltage, kilovolts.
[5] Time — residence time in field during poling.
[6] p — calculated pyroelectric response for blend.

Example 4

Films were prepared as per Example 3 using polyethylmethacrylate (Elvacite® 2042 from DuPont) instead of polyvinyl acetate. Results of this film blend were:

4

0 044 702

| Sample | PVF$_2$[1] | PEMA[2] | DMF[3] | KV[4] | Time[5] (sec) | p[6] (volts/ mil °C) |
|---|---|---|---|---|---|---|
| A | 6 | 4 | 40 | 6 | 8 | 5.1 |
| B | 7 | 3 | 40 | 6 | 8 | 4.8 |
| C | 8 | 2 | 40 | 6 | 8 | 4.0 |

[1] PVF$_2$ — polyvinylidene fluoride resin, grams.
[2] PEMA — polyethyl methacrylate resin, grams.
[3] DMF — dimethylformamide, grams.
[4] KV — poling voltage, kilovolts.
[5] Time — residence time in field during poling.
[6] p — calculated pyroelectric response for blend.

## Example 5

Polyvinylidene fluoride (240 grams of Kureha 1100), polymethylmethacrylate (110 grams of Rohm & Haas Acryloid® A-11) and 1360 grams of dimethylformamide were charged into a container. The contents were stirred and maintained at a temperature of 200°F (93°C) for 20 hours. The resulting solution, when cooled to room temperature, had an acceptable viscosity for knife coating.

The viscous solution was knife coated with a 9 inch knife coater onto one ounce copper foil and the coated film was dried at 275°F (135°C) for 1.5 to 3.0 minutes.

The film was subsequently heated to 400°F (204°C) for 1.5 to 3.0 minutes and quenched to 95°F (35°C) within 8 to 15 seconds. The film was poled as described in U.S. Patent Nos. 4,067,056; 4,079,437; and 4,089,034 and the resulting pyroelectric response was 2.3 to 4.0 V/mil °C.

## Example 6

A solution of polyvinylidene fluoride (Solef® 1012, 70 percent by weight) and polymethyl methacrylate (Rohm & Haas Acryloid® A11, 30 percent by weight) in dimethyl formamide was prepared at a solids content of 20 percent by weight. This solution was coated onto 0.6 mil aluminum foil using a 6 inch knife coater, dried at 270°F for 15 minutes, heated to 425°F (220°C) for 10 minutes, and subsequently cooled rapidly. The resulting film, 0.9 mil thick, was poled as described in U.S. Patent Nos. 4,067,056; 4,079,437; or 4,089,034. The poled film exhibited a pyroelectric response of 3.9 V/mil-°C. The piezoelectric constants, $d_{31}$ and $d_{32}$, were found to be equal at a value of $d_{31} = d_{32} = 3_p$C/N. In defining the piezoelectric constants the convention of calling the knife coater direction 1, the transverse direction 2, and the direction perpendicular to the plane of the film 3 was employed, and pC is picocoulombs, N is Newtons, and d is the piezoelectric constant.

## Example 7

A solution of polyvinylidene fluoride (Solef® 1012, 70 percent by weight) and polymethylmethacrylate (Rohm & Haas Acryloid® A-11, 30 percent by weight) in dimethyl formamide was prepared at a solids content of 20 percent by weight. This solution was coated onto 0.6 mil aluminum foil, using a 6 inch (15.24 cm) knife coater, dried at 275°F (135°C) for 15 minutes, heated to 425°F (220°C) for 10 minutes, and subsequently cooled rapidly. Sections of the resulting film, about 0.9 mil (0.023 mm) in thickness, were poled as described in U.S. Patent Nos. 4,067,056; 4,079,437; or 4,089,034. The pyroelectric output, volts per °C, of the sections was evaluated, as were the wide angle X-ray scattering curves in the region of 20 from 14° to 24°. The films exhibited crystalline scattering peaks at $2\theta = 21°$. This peak is characteristic of the $\beta$-crystalline morphology. The integrated crystalline intensities of these peaks in arbitrary, but self-consistent units correlate with the pyroelectric output as shown in the table below:

| Sample | $I_c$ | Pyroelectric Output (V/°C) |
|---|---|---|
| 1 | 3.90 | 4.30 |
| 2 | 3.86 | 4.28 |
| 3 | 1.98 | 1.63 |
| 4 | 1.34 | .11 |

### Example 8

A blend of 70 percent by weight polyvinylidene fluoride (experimental Pennwalt resin — Kynar® 960) and 30 percent by weight polymethylmethacrylate/methylmethacrylate-ethyl methacrylate copolymer (DuPont Lucite® 147K) was obtained by melt blending in an extruder. A 4 mil (0.1 mm) thick film was obtained from the extrudate by reheating to 220°C and forming in a press. This film was removed from the press and rapidly cooled by dipping into ice water to prevent crystallization. The film was then poled as described in U.S. Patent Nos. 4,067,056; 4,079,437; or 4,089,034. The poled film exhibited a pyroelectric response of 0.8 V/mil-°C.

### Example 9

Thirty-four grams of dimethylformamide were added to 6.0 grams polyvinylidene fluoride (Pennwalt Kynar® 301F), and the mixture was agitated for 2 hours at ambient temperature to dissolve the resin. Ten grams of 40 percent by weight polymethylmethacrylate in methylethylketone (Rohm and Haas Acryloid® A-101) were then added and the mixture was agitated for an hour at ambient temperature to yield a 60 to 40 weight ratio of $PVF_2$ to PMMA at a combined concentration of 20 percent by weight in the total solution.

A film was cast from a portion of the resulting milky solution onto 0.7 mil (0.018 mm) thick aluminum foil using an 18 inch knife coater. The coated foil was immediately placed on a 150°C hot plate for 10 minutes to drive off most of the DMF, then placed in a 150°C oven for 20 minutes and then rapidly cooled to room temperature.

Gold was sputtered onto the resulting approximately one mil thick coating to form an electrode for poling. The coated foil was heated in an oven to 105°C over a 12 minute interval with 1,250 volts applied between the gold electrode and the aluminum foil substrate. The coated foil was held at this temperature and voltage conditions for 60 minutes and then cooled to below 50°C over a 15 minute period while the voltage was maintained. The measured pyroelectric output was 2.6 volts per °C.

### Example 10

Polyvinylidene fluoride (Pennwalt Kynar® 301F) and polymethylmethacrylate (Rohm and Haas Acryloid® A-11) were combined in 60 to 40 ratio by weight, respectively, and mixed with sufficient dimethylformamide to provide a concentration of 6.67 percent by weight of the combined resins in solution.

The resulting solution was filtered and then distributed from a hypodermic syringe over the surface of a silicon IC (integrated circuit) slice. The IC slice was then placed in a container, and the container was heated by infrared lamps and purged with nitrogen to drive off most of the DMF solvent.

The coated IC slice was transferred to a 150—200°C oven for 40 minutes and was then rapidly cooled to room temperature.

Gold was sputtered onto the resultant approximately 0.6 mil (0.015 mm) average thickness coating to form an electrode for poling. The coated IC slice was then heated in an oven to 120°C over a 10 minute period while a potential of 600 to 750 volts was applied between the gold electrode and the silicon substrate. The coated IC slice was held at these temperature and voltage conditions for 30 minutes and was then cooled to below 86°C over a 10 minute period while the voltage was maintained. The measured pyroelectric output equaled 1.1 volts per °C or about 1.9 volts per mil°C.

### Claims

1. A pyroelectric and isotropic piezoelectric polymeric film comprising a blend of polyvinylidene fluoride and at least one polymer which is miscible with said polyvinylidene fluoride at a temperature above the melting point thereof, the film not having been oriented mechanically.

2. A polymeric film according to Claim 1, wherein said polyvinylidene fluoride comprises at least 50 percent by weight of said blend.

3. An article having a pyroelectric and isotropic piezoelectric polymeric coating disposed on at least a portion thereof, said polymeric coating comprising a blend of polyvinylidene fluoride and at least one polymer which is miscible with said polyvinylidene fluoride at a temperature above the melting point thereof, the polymeric material being substantially in the $\beta$-crystalline state.

4. An article according to Claim 3, wherein said polyvinylidene fluoride comprises at least 50 percent by weight of said blend.

5. An article or a film according to any one of Claims 1 to 4, wherein said polymer is at least of acrylate, methacrylate or polyvinylacetate.

6. A method for forming a pyroelectric and isotropic piezoelectric polymeric film comprising:

(a) forming a coating solution of a polymer blend in a suitable solvent, said polymer blend comprising polyvinylidene fluoride and at least one polymer which is miscible with said polyvinylidene fluoride at a temperature above the melting point thereof;

(b) solvent casting said solution to form a thin polymeric film;

(c) removing the solvent from said film and heating same to a sufficient temperature and for a sufficient time to render said film substantially amorphous;

(d) cooling said film at a rate and to a temperature sufficient to prevent crystallization of said film; and

(e) polarizing said film to render same pyroelectric and isotropically piezoelectric.

7. A process for forming a pyroelectric and isotropic piezoelectric polymeric film comprising:

(a) intimately mixing a polymer blend at a sufficient temperature to cause a homogeneous mixture, said blend comprising polyvinylidene fluoride and at least one polymer miscible therewith at a temperature above the melting point of said polyvinylidene fluoride;

(b) forming a film of said homogeneous mixture;

(c) heating said film to a temperature above the melting point of said polyvinylidene fluoride for a sufficient time to render said film substantially amorphous;

(d) cooling said film at a rate and to a temperature sufficient to prevent crystallization of said film; and

(e) polarizing said film to render same pyroelectric and isotropically piezoelectric.

8. A process for forming a pyroelectric and isotropic piezoelectric polymeric coating on at least a portion of a device comprising:

(a) forming a coating solution of a polymer blend in a suitable solvent, said polymer blend comprising polyvinylidene fluoride and at least one polymer which is miscible with said polyvinylidene fluoride at a temperature above the melting point thereof;

(b) solvent casting said solution on said device to form a thin polymeric coating on at least a portion thereof;

(c) removing the solvent from said coating and heating same to a sufficient temperature and for a sufficient time to render said coating substantially amorphous;

(d) cooling said coating at a rate and to a temperature sufficient to prevent crystallization of said coating; and

(e) polarizing said coating to render same pyroelectric and isotropically piezoelectric.

9. A process according to any one of Claims 6 to 8, wherein said polyvinylidene fluoride comprises at least 50 percent by weight of said blend.

10. A process according to any one of Claims 6 to 9, wherein said polymer is at least one of an acrylate, a methacrylate or a polyvinylacetate.

**Revendications**

1. Une pellicule polymère pyroélectrique et piézoélectrique isotrope comprenant un mélange de fluorure de polyvinylidène et d'au moins un polymère qui est miscible avec ledit fluorure de polyvinylidène à une température supérieure au point de fusion de celui-ci, la pellicule n'ayant pas été orientée mécaniquement.

2. Une pellicule polymère selon la revendication 1, dans laquelle ledit fluorure de polyvinylidène constitue au moins 50% du poids dudit mélange.

3. Un article ayant, sur au moins une de ses portions, un revêtement polymère pyroélectrique et piézoélectrique isotrope, ledit revêtement polymère comprenant un mélange de fluorure de polyvinylidène et d'au moins un polymère qui est miscible avec ledit fluorure de polyvinylidène à une température supérieure à son point de fusion, la matière polymère étant essentiellement à l'état cristallin $\beta$.

4. Un article selon la revendication 3, dans lequel ledit fluorure de polyvinylidène constitue au moins 50% en poids dudit mélange.

5. Un article ou une pellicule selon l'une quelconque des revendications 1 à 4, où ledit polymère est au moins un acrylate, méthacrylate ou acétate de polyvinyle.

6. Un procédé pour former une pellicule polymère pyroélectrique et piézoélectrique isotrope comprenant:

(a) la formation d'une solution de revêtement d'un mélange de polymères dans un solvant approprié, ledit mélange de polymères comprenant du fluorure de polyvinylidène et au moins un polymère qui est miscible avec ledit fluorure de polyvinylidène à une température supérieure au point de fusion de celui-ci;

(b) la coulée au solvant de ladite solution pour former une pellicule polymère mince;

(c) l'élimination du solvant de ladite pellicule et le chauffage de celle-ci à une température suffisante et pendant une durée suffisante pour rendre ladite pellicule essentiellement amorphe;

(d) le refroidissement de ladite pellicule à une vitesse et à une température suffisantes pour éviter la cristallisation de ladite pellicule; et

(e) la polarisation de ladite pellicule pour lui conférer un caractère pyroélectrique et piézoélectrique isotrope.

7. Un procédé pour former une pellicule polymère pyroélectrique et piézoélectrique isotrope comprenant:

(a) le mélange intime d'un mélange de polymères à une température suffisante pour former un mélange homogène, ledit mélange comprenant du fluorure de polyvinylidène et au moins un polymère miscible avec celui-ci à une température supérieure au point de fusion dudit fluorure de polyvinylidène;

(b) la formation d'une pellicule dudit mélange homogène;

(c) le chauffage de ladite pellicule à une température supérieure au point de fusion dudit fluorure de polyvinylidène pendant une période suffisante pour rendre ladite pellicule essentiellement amorphe;

(d) le refroidissement de ladite pellicule à une vitesse et à une température suffisantes pour éviter la cristallisation de ladite pellicule; et

(e) la polarisation de ladite pellicule pour lui conférer un caractère pyroélectrique et piézoélectrique isotrope.

8. Un procédé pour former un revêtement polymère pyroélectrique et piézoélectrique isotrope sur au moins une portion d'un dispositif comprenant:

(a) la formation d'une solution de revêtement d'un mélange de polymères dans un solvant approprié, ledit mélange de polymères comprenant du fluorure de polyvinylidène et au moins un polymère qui est miscible avec ledit fluorure de polyvinylidène à une température supérieure au point de fusion de celui-ci;

(b) la coulée au solvant de ladite solution sur ledit dispositif pour former un revêtement polymère mince sur au moins une portion de celui-ci;

(c) l'élimination du solvant dudit revêtement et le chauffage de celui-ci à une température suffisante et pendant une durée suffisante pour rendre ledit revêtement essentiellement amorphe;

(d) le refroidissement dudit revêtement à une vitesse et à une température suffisantes pour éviter la cristallisation dudit revêtement; et

(e) la polarisation dudit revêtement pour lui conférer un caractère pyroélectrique et piézoélectrique isotrope.

9. Un procédé selon l'une quelconque des revendications 6 à 8, dans lequel ledit fluorure de polyvinylidène constitue au moins 50% du poids dudit mélange.

10. Un procédé selon l'une quelconque des revendications 6 à 9, dans lequel ledit polymère est au moins un acrylate, un méthacrylate ou un acétate de polyvinyle.

**Patentansprüche**

1. Pyroelektrischer und isotroper piezoelektrischer Polymerfilm mit einem Gemisch aus Polyvinylidenfluorid und mindestens einem Polymer, das mit dem Polyvinylidenfluorid bei einer über dessen Schmelzpunkt liegenden Temperatur mischbar ist, wobei der Film nicht mechanisch orientiert worden ist.

2. Polymerfilm nach Anspruch 1, dadurch gekennzeichnet, daß das Gemisch zu mindestens 50 Gewichtsprozent aus dem Polyvinylidenfluorid besteht.

3. Gegenstand, der mindestens auf einem Teil desselben mit einem pyroelektrischen und isotropen piezoelektrischen Polymerüberzug versehen ist, der ein Gemisch aus Polyvinylidenfluorid und mindestens einem Polymer enthält, das mit dem Polyvinylidenfluorid bei einer über dessen Schmelzpunkt liegenden Temperatur mischbar ist, wobei sich das polymere Material im wesentlichen im $\beta$-kristallinen Zustand befindet.

4. Gegenstand nach Anspruch 3, dadurch gekennzeichnet, daß das Gemisch zu mindestens 50 Gewichtsprozent aus dem Polyvinylidenfluorid besteht.

5. Gegenstand oder Film nach einem der Ansprüche 1 bis 4, dadurch gekennzeichnet, daß das Polymer mindestens ein Polymer eines Acrylats oder Methacrylats oder Polyvinylacetat ist.

6. Verfahren zum Herstellen eines pyroelektrischen und isotropen piezoelektrischen Films, in dem

(a) eine Überzugslösung eines Polymergemisches in einem geeigneten Lösungsmittel hergestellt wird, wobei das Polymergemisch Polyvinylidenfluorid und mindestens ein Polymer enthält, das mit dem Polyvinylidenfluorid bei einer über dessen Schmelzpunkt liegenden Temperatur mischbar ist;

(b) aus der genannten Lösung im Tauchformverfahren ein dünner Polymerfilm hergestellt wird;

(c) das Lösungsmittel von dem Film entfernt und dieser so lange auf eine solche Temperatur erhitzt wird, daß der Film in einen im wesentlichen amorphen Zustand überführt wird;

(d) der Film mit einer solchen Geschwindigkeit auf eine solche Temperatur abgekühlt wird, daß eine Kristallisation des Films verhindert wird; und

(e) durch Polarisieren des Films dieser in einen pyroelektrischen und isotropen piezoelektrischen Zustand überführt wird.

7. Verfahren zum Herstellen eines pyroelektrischen und isotropen piezoelektrischen Film, in dem

(a) ein Polymergemisch bei einer solchen Temperatur gründlich gemischt wird, daß ein homogenes Gemisch erhalten wird, wobei das Gemisch Polyvinylidenfluorid und mindestens ein Polymer enthält, das mit dem Polyvinylidenfluorid bei einer über dessen Schmelzpunkt liegenden Temperatur mischbar ist;

(b) aus dem homogenen Gemisch ein Film hergestellt wird;

(c) der Film so lange auf eine über dem Schmelzpunkt des Polyvinylidenfluorids liegende Temperatur erhitzt wird, daß der Film in eine im wesentlichen amorphen Zustand überführt wird;

(d) der Film mit einer solchen Geschwindigkeit auf eine solche Temperatur abgekühlt wird, daß eine Kristallisation des Films verhindert wird; und

(e) durch Polarisieren des Films dieser in einen pyroelektrischen und isotropen piezoelektrischen Zustand überführt wird.

8. Verfahren zum Herstellen eines pyroelektrischen und isotropen piezoelektrischen Polymerüberzuges auf mindestens einem Teil einer Vorrichtung, in dem

(a) eine Überzugslösung eines Polymergemisches in einem geeigneten Lösungsmittel hergestellt wird, wobei das Polymergemisch Polyvinylidenfluorid und mindestens ein Polymer enthält, das mit dem Polyvinylidenfluorid bei einer über dessen Schmelzpunkt liegenden Temperatur mischbar ist;

(b) aus der genannten Lösung im Tauchformverfahren ein dünner Polymerüberzug auf mindestens einem Teil der Vorrichtung hergestellt wird;

(c) das Lösungsmittel von dem Überzug entfernt und dieser so lange auf eine solche Temperatur erhitzt wird, daß der Überzug in einem im wesentlichen amorphen Zustand überführt wird;

(d) der Überzug mit einer solchen Geschwindigkeit auf eine solche Temperatur abgekühlt wird, daß eine Kristallisation des Überzuges verhindert wird; und

(e) durch Polyrisieren der Überzuges dieser in einen pyroelektrischen und isotropen piezoelektrischen Zustand überführt wird.

9. Verfahren nach einem der Ansprüche 6 bis 8, dadurch gekennzeichnet, daß das Gemisch zu mindestens 50 Gewichtsprozent aus dem Polyvinylidenfluorid besteht.

10. Verfahren nach einem der Ansprüche 6 bis 9, dadurch gekennzeichnet, daß das Polymer mindestens ein Polymer eines Acrylats oder Methacrylats oder ein Polyvinylacetat ist.